# EUROPÄISCHE PATENTANMELDUNG

(11) **EP 4 693 380 A1**
(43) Veröffentlichungstag der Anmeldung: **11.02.2026**
(21) Anmeldenummer: 24193172.4
(22) Anmeldetag: 06.08.2024
(51) Int. Cl.: H01L 21/56, H01L 23/29, H01L 23/00

(54) **HALBLEITERBAUELEMENT**

(71) Anmelder: Siemens Aktiengesellschaft, 80333 München (DE)
(72) Erfinder: BIGL, Thomas, 91074 Herzogenaurach (DE); BORWIECK, Carsten, 14052 Berlin (DE); KNOFE, Rüdiger, 14513 Teltow (DE); PIHALE, Sven, 91792 Stopfenheim (DE); ÜBLER, Matthias, 92289 Ursensollen (DE)
(74) Vertreter: Siemens Patent Attorneys

(57) **Zusammenfassung**

Die Erfindung betrifft ein Halbleiterbauelement, einen Halbleiterchip mit einer Oberfläche, auf der sich ein integrierter Schaltkreis befindet im Verbund mit einem Substrat, wie einer Platine, mit mehreren darauf befindlichen Kontakten und/oder Leitungen, wobei eine Vielzahl leitender Kontakte die Oberfläche des Halbleiterchips mit der Oberfläche des Substrats verbindet und wobei die Leerstellen im Verbund aus Halbleiterchip und Substrat durch einen Underfiller, der sowohl die elektrischen Kontakte gegeneinander und die Umgebung isoliert als auch den Verbund zwischen Halbleiterchip und Substrat stabilisiert, gefüllt ist. Durch die Erfindung wird erstmals die Einführung von deagglomeriert vorliegenden Nanopartikeln in die Reaktionsharzmischung, die als flüssiges Underfill-Material vorliegt, vorgeschlagen, die, ohne thermomechanische Beeinträchtigungen des Underfill-Materials zu verursachen, dessen Rissbeständigkeit und Haftungseigenschaften gegenüber dem bekannten Stand der Technik deutlich erhöhen.

## Beschreibung

### Technisches Gebiet

Die Erfindung betrifft ein Halbleiterbauelement, einen Halbleiterchip mit einer Oberfläche, auf der sich ein integrierter Schaltkreis befindet im Verbund mit einem Substrat, wie einer Platine, mit mehreren darauf befindlichen Kontakten und/oder Leitungen, wobei eine Vielzahl leitender Kontakte die Oberfläche des Halbleiterchips mit der Oberfläche des Substrats verbindet und wobei die Leerstellen im Verbund aus Halbleiterchip und Substrat durch einen Underfiller, der sowohl die elektrischen Kontakte gegeneinander und die Umgebung isoliert als auch den Verbund zwischen Halbleiterchip und Substrat stabilisiert, gefüllt ist.

### Technischer Hintergrund

Zum "Unterfüllen" eines Halbleiterbauelements wird eine Substanz eingesetzt, die flüssig appliziert wird, damit sie in alle Zwischenräume, Ritze und Spalten fließen kann. Die Verteilung der flüssigen Substanz - im Folgenden "Vorprodukt" genannt, weil daraus durch Vernetzung ein Polymer entsteht - nennt man "Unterfüllen". Nach dem "Unterfüllen" wird das applizierte Vorprodukt durch UV-Bestrahlung und/oder Temperatureintrag zum Polymer gehärtet. Das zunächst flüssige Vorprodukt eines Polymers, z.B. eines Epoxidharzes wird dabei polymerisiert also hart und in den meisten Fällen auch unschmelzbar, wenn es eine duromere Verbindung, wie z.B. Epoxid, ist. Das Duromer ummantelt dann die Kontakte und füllt die Bonding-Zwischenräume im Halbleiterbauelement, dabei gewährleistet es sowohl die Isolationen als auch die Verklebungen auf dem Halbleiterbauelement.

So festigt das ausgehärtete Polymer die Lötverbindungen und verbessert die Beständigkeit des Halbleiterbauelements gegenüber Stößen, Vibrationen und beschleunigungsbedingten Belastungen. Nachdem der Chip auf das Substrat, respektive die Platine oder Leiterplatte mit den Leitungen und/oder Kontakten aufgesetzt ist und das Löten der elektrischen Kontakte mit dem integrierten Schaltkreis auf dem Chip erfolgt ist, füllt das Vorprodukt, der "Underfiller" im Halbleiterbauelement alle Zwischenräume formschlüssig, weil es flüssig ist. In einem anschließenden Prozessschritt wird der verteilte Underfiller zum Kunststoff-Formkörper, der die Isolationen und die Verklebungen auf dem Halbleiterbauelement gewährleistet, gehärtet. Beim Härten des Underfillers verliert dieser jedoch regelmäßig chemisch und/oder thermisch an Volumen, das heißt er schrumpft, was zu Spannungen und thermomechanischem Stress an den Grenzflächen von Halbleiterbauelement und Polymer führt, die in der Regel in Rissbildung am Polymer enden. Diese Rissbildung, vor allem an Kanten und/oder Ecken, gilt es im Sinne einer langen Lebensdauer des Halbleiterbauelements zu reduzieren und zu verhindern.

Daher werden - um den Schrumpf zu minimieren, als flüssige Vorprodukte, respektive "Underfill-Material" - Harze, die mit mineralischen Füllstoffen gefüllt sind und die thermisch und/oder UV-aktivierbar zu elektrisch isolierenden Hochpolymeren reagieren, eingesetzt. Diese werden als einkomponentige "1K" oder zweikomponentige "2K" Varianten genutzt, wobei 1-K-Systeme vorrangig, aber nicht notwendigerweise, als Homopolymerisate und 2-K-Varianten als "Harz und Härter"-Polymerisate vorliegen. Die Applikation des Underfill-Materials erfolgt nach dem Löten auf das bestückte Halbleiterbauelement, insbesondere das Substrat und/oder die Platine. Das Underfill-Material wird vorzugsweise zwischen -z.B. mittels Dispenser-Halbleiterchips mit flächigen und/oder mehreren, einzelnen Strukturen, beispielsweise auch in Kugelform bei Ball-Grid-Arrays, und das Substrat in Spalten um die Kontaktpads herum, sowie als Isolation für die Leitungen appliziert. Diese Applikation dient zum Verkleben, elektrischen Isolieren und auch dazu, die mechanischen Spannungen aufgrund des thermischen Mismatches durch unterschiedliche thermische Ausdehnungskoeffizienten der Fügepartner zu reduzieren.

Zwei Punkte sind bei der Applikation des Underfillers, also des flüssigen, noch nicht gelierten und ungehärteten Underfill-Materials, von zentraler Bedeutung:
- zum einen, das Fließverhalten des Underfillers, weil er als so genannter "Capillary Flow"-Underfill, sehr enge Spalte unterhalb des/der Halbleiterchips und/oder zwischen den elektrischen Kontaktierungen zu benetzen und/oder auszufüllen hat und,
- zum anderen, dass der Underfiller im Moment der Gelierung und folgenden Aushärtung mit nur geringem chemischem und/oder thermischem "Schrumpf" möglichst ohne Fehlstellen an den Fügepartnern anhaftend auspolymerisiert. Dieser Volumenverlust oder "Schrumpf" beim Aushärten des Harzes führt zu thermomechanischem Stress an den Grenzflächen zwischen den Fügepartnern.

In der Regel findet oftmals ein Epoxidharz als flüssiges Harzmatrix-Basismaterial für den Underfiller Verwendung, da dieses Material in der Elektrotechnik als Benchmark seit Jahrzehnten aufgrund seiner chemischen Resistenz, thermischen Langlebigkeit und guten isolierenden Eigenschaften, sei es als kationisches oder anionisches Homopolymerisat oder als heißhärtender 2-K-Polyester im Zusammenspiel mit Härtern wie Anhydriden etabliert ist.

Im mineralisch ungefüllten Zustand weisen ausgehärtete Epoxidharze einen linearen, thermischen Ausdehnungskoeffizient (engl. Linear coefficient of thermal expansion, "LCTE") von typischerweise ca. 65 µm/(m*K) auf und zeigen damit ein deutlich höheres Volumenveränderungsverhalten (Expansion bzw. Kontraktion) unter Temperatur als die zu unterfüllenden Chipmaterialien aus z.B. Silizium, Siliciumcarbid, etc. oder das Substrat. Dieser Unterschied im Ausdehnungsverhalten der Materialien ("CTE Missmatch") verbietet es, ungefüllte Epoxidharze als Underfiller für Halbleiterchips zu verwenden, da beim Aushärten aufgrund des chemischen Schrumpfes von bis zu 8% und der o.g. linearen Ausdehnung des Epoxidhochpolymers beim Abkühlen nach dem Heißhärten Spalte und damit Ablösungen und/oder Delaminationen an den Grenzflächen zum Halbleiterchip entstehen.

In diesen Fehlstellen kommt es dann rasch zu Teilentladungen und Durchschlägen im elektrischen Betrieb, zur Ausbildung von lebensdauerreduzierenden Mikroklimaten unter Feuchteeinfluss und/oder zur Einlagerung von Fremdpartikeln.

Aus diesem Grund werden die Harz-Basismaterialien eines Underfillers, wie z.B. Epoxidharze, mit Mineralfüllstoffen mittel- bis hochgefüllt. Diese Füllstoffe, oftmals auf Basis von splittrigen und/oder sphärischen, amorphen und/oder kristallinen Quarzmehlen und Quarzguten, Nitriden, Aluminiumoxiden, Dolomiten etc. sorgen für eine Verringerung des chemischen Schrumpfes im Moment des Gelierens und Aushärtens und zu einer Gesamtverringerung des Ausdehnungskoeffizienten, da Füllstoffe für gewöhnlich einen sehr viel geringeren CTE (thermischen Ausdehnungskoeffizienten) aufweisen als Epoxidharz.

Beispielsweise erhält man durch Füllen eines Epoxid-Basisharzes mit 1:0.95-molarstöchiometrischem Anhydrid als Härterkomponente mit ca. 46 Vol% kristallinem Quarzmehl eine Verringerung des Gesamt-CTE des somit "mittel" gefüllten Epoxidharzes von ca. 65 µm/(m*K) (ungefüllt) auf ca. 32 µm/(m*K) (gefüllt). Verwendet man dagegen 46 Vol% amorphes Quarzgut, so verringert sich der Gesamt-CTE des gefüllten Werkstoffes auf ca. 20-25 µm/(m*K). Ein derartiges Material führt also beim Vergießen zu deutlich weniger thermomechanischem Stress zwischen den Grenzflächen der Fügepartner als das ungefüllte Epoxidharz.

Jedoch ist ein weiteres Phänomen von zentraler Bedeutung, nämlich die Sprödigkeit des Komposits. Epoxidharze weisen per se eine hohe Sprödigkeit auf. Daher besitzen sie keine sonderlich ausgeprägte Duktilität unter Last, d.h. sie brechen leicht und abrupt bei Überschreitung der Festigkeit unter Biege- und Zugbelastung. Aber die Bruchdehnung z.B. von ungefülltem Epoxidharz im Vergleich zu einem oben beschriebenen, gefüllten Epoxidharz nimmt noch weiter ab von ca. 5-6% des ungefüllten Epoxidharzes auf 0.9-1.3% des gefüllten Epoxidharzes. Daher wird versucht, wegen der Sprödigkeit ein möglichst gering gefülltes Epoxidharz als Underfiller einzusetzen.

Je höher mineralisch gefüllt ein Werkstoff ist, desto steifer (Modul) und spröder (Bruchdehnung) wird er, da die organische Matrix abnimmt, die die Last aufnehmen kann.

Zwar nimmt mit dem o.g. mineralischen Füllen eines Basis-Epoxidharzes die Bruchzähigkeit (z.B. K_{IC}-Wert) selbst von 0.3-0.4 MPa*m^{1/2} auf ca. 1.9-2.0 MPa*m^{1/2} zu, d.h. es ist eine bedeutend höhere Spannungsintensität vor etwaig vorhandenen Rissspitzen im Werkstoff nötig, um ihn gänzlich zum Brechen zu bringen. Jedoch ist ebenso, wie erwähnt, die maximale Bruchdehnung im gefüllten Zustand verringert.

Gerade beim Verguss von Halbleiterchips mit engen Spalten, Kanten sowie Spitzen, kann es an diesen neuralgischen Punkten dennoch zu Rissen kommen, da im Moment des Warmaushärtens bei Temperaturen von bis zu 150°C durch chemischen Schrumpf und der anschließenden Kontraktion durch Abkühlung auf Raumtemperatur an Ecken und Kanten zu lokalen Spannungsintensitätsüberhöhungen kommen kann, die zum Überschreiten von Bruchdehnung, Festigkeit und Risszähigkeit führen. Es zeigen sich dann im Schliffbild bei derartig vergossenen Aufbauten Risse an Kanten bzw. Delaminationen entlang der Oberflächen der Fügepartner. Diese Fehlstellen führen im Betrieb zu dielektrischen Ausfällen oder bei fortschreitender Rissausbreitung zu elektrischen Defekten im Halbleiterchip und/oder zu mechanischen Ausfällen bei den Substraten.

Um die Risszähigkeit zur erhöhen, versuchen manche Underfill-Anbieter, die 1K- und 2K-Mischungen -- oft nur auf expliziten Kundenwunsch hin -- mit Modifikatoren zu verändern und so die internen Spannungszustände nach der Aushärtung zu verringern. Diese Additive oft unbekannter Natur werden den Rezepturen untergemischt, um die Werkstoffzähigkeit zu erhöhen und Rissinitiierungstendenzen an Spitzen und Kanten zu verringern bzw. eine Risspropagation unter Lastspielen zu verlangsamen. Es handelt sich oft um weiche Silikon- und/oder Siloxanpartikel oder die dem Fachmann bekannten Zähmodifikatoren auf Basis von CTBN-Partikeln (CarboxylTerminierte polyButadienNitrilkautschuke), also gummiartige, fraktalagglomerierte und aggregierte Weichpartikel mit Abmessungen von mehreren zehn bis zu hundert Mikrometern. Es kommen auch seltener spezielle, chemisch veränderte Härterverbindungen mit langkettigen und flexiblen Bausteinen zum Einsatz, die eine gewisse Duktilität in das Hochpolymer durch chemischen Co-Einbau einführen sollen.

All diese Modifikatoren, insbesondere trocken einzumischende Gummipartikel auf Basis CTBN und/oder andere Kautschuke, Silikone und Siloxane, die bekanntermaßen seit Jahrzehnten recht erfolglos als Zähmodifikatoren für Epoxidharze eingesetzt werden, haben keinen besonders ausgeprägten positiven Einfluss auf die Risszähigkeit, da sie - um den gewünschten Effekt zur erzielen - in so hohen Anteilen zuzumischen sind, dass die damit einhergehende überproportionale Verschlechterung der Fließverhaltens, insbesondere im Zusammenspiel mit zusätzlich hohen Anteilen an mineralischem Füllstoff diese gefüllten Harze als Underfiller ungeeignet macht. Es handelt sich dann nämlich effektiv um eine Gesamtfüllstofferhöhung mit dem Ziel einer Verbesserung des Rissverhaltens auf Kosten der Fluidität, welche aber für die Anwendung als Underfiller zwingend hochgehalten werden muss, um eine gute Spaltgängigkeit und/oder Spaltfüllung zu gewährleisten.

### Zusammenfassung der Erfindung

Aufgabe der vorliegenden Erfindung ist es daher, ein Material für den Underfill-Prozess bei der Herstellung von Halbleiterbauelementen zur Verfügung zu stellen, das die oben genannten Nachteile des Standes der Technik überwindet.

Gegenstand der Erfindung ist daher ein Halbleiterbauelement, einen Halbleiterchip auf einem Substrat mit einer Vielzahl von Leitungen und Kontakten umfassend, so dass die Vielzahl der Leitungen und Kontakte die Schaltungen auf der Oberfläche des Halbleiterchips mit den Kontakten auf dem Substrat verbinden, wobei zwischen dem Halbleiterchip und dem Substrat sowie um die Vielzahl von Leitungen und Kontakten herum ein elektrisch isolierendes Underfill-Material jeweils form- und stoffschlüssig vorgesehen ist, das in einer Harzmatrix de-agglomerierte Nanopartikel und Mikrofüllstoffe umfasst.

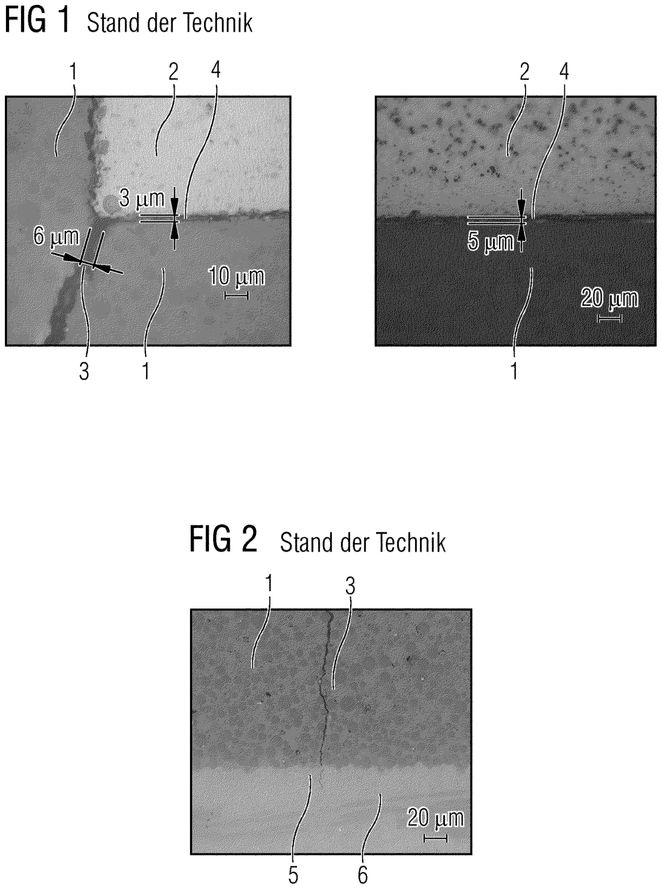

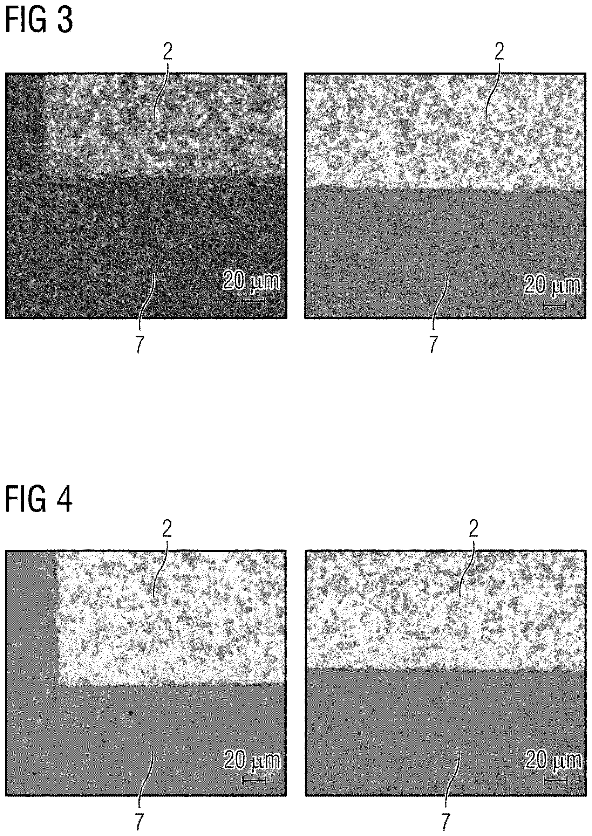

Das "form- und stoffschlüssige Vorliegen" des Underfill-Materials wie in den Figuren 3 und 4 gezeigt, heißt hier, dass im Vergleich zu Nanopartikel-freien Referenzproben, wie in den Figuren 1 und 2 gezeigt, weniger Risse oder eben nur ganz schmale und kurze Risse sowie geringere Delamination am Halbleiterchip oder am Substrat zu beobachten ist.

Allgemeine Erkenntnis der Erfindung ist es, dass de-agglomerierte Nanopartikel, wie sie die gemäß der Erfindung im Underfiller vorhanden sind
- die Höhe der Glasübergangstemperatur des Underfiller-Materials nicht herabsetzen, da sie die Netzwerkdichte nicht verringern,
- eine viskositätssenkende Wirkung im Zusammenspiel mit mineralischen Mikrofüllstoffen zeigen, da die Nanopartikel, beispielsweise mit einem d50-Partikeldurchmesser </=200nm zu einer Erhöhung der Packungsdichte der mikroskaligen Mineralfüllstofffraktion führen, womit eine Viskositätserniedrigung einhergeht, da die Nanopartikel gleichsam als "Kugellager" zwischen den großen Füllstoffpartikeln fungieren.

Insbesondere durch Beimischung von deagglomerierten Nanopartikel und besonders vorteilhafterweise von deagglomerierten Core/Shell-Nanopartikeln - beispielsweise auf Basis eines weichen und elastischen Kerns, beispielsweise auch im Zusammenhang mit einer Oberflächenmodifikation, kann die Risszähigkeit des resultierenden Werkstoffes bei Beimengungen von sogar weniger als 2 Gew.-% bezogen auf das Gesamtgewicht des flüssigen Underfillers sehr deutlich erhöht werden, um die besagten Rissphänomene und Haftungsprobleme an den Fügepartnern effektiv zu unterdrücken. Die Nanopartikel können in weit höheren Gew%-Anteilen im Underfill-Material vorliegen, beispielsweise von 0,3 Gew% bis zu 30 Gew%, bezogen auf die Gesamtmasse des Underfill-Materials ohne Mikrofüllstoff. Mit Mikrofüllstoff-Füllung im Underfill-Material liegen die Bereiche für Nanopartikel-Füllung bei 2 Gew% bis 15 Gew%, beispielsweise bei 3,5 Gew% bis 12 Gew%.

Beispielsweise werden Core-Shell-Nanopartikel mit weichem, elastischem Kern eingesetzt, es können aber auch beliebige andere Nanopartikel, mit oder ohne Oberflächenmodifikation, mit oder ohne Shell, also Hülle, erfolgreich genutzt werden. Des Weiteren ist vorgesehen, dass beliebige Kombinationen und Gemische aus Nanopartikel nach beispielhaften Ausführungsformen hier zur Verhinderung der Rissbildung und zur besseren Haftung des Underfill-Materials am Chip, den Leitungen, Kontakten, Kontaktpads, am Substrat und/oder an der Platine, eingesetzt werden.

Als Nanopartikel werden Teilchen bezeichnet, deren äußere Abmessungen zumindest in einer Dimension im Nanometer Bereich liegen. Vorliegend werden bevorzugt Nanopartikel eingesetzt, die in allen drei Dimensionen im Nanometerbereich liegen.

Als Core/Shell Nanopartikel werden Teilchen bezeichnet, bei denen ein Kern, insbesondere ein sphärischer Kern einer Substanz vorliegt, der mit einer äußeren Hülle einer anderen Verbindung ummantelt ist, wobei diese Hülle beispielsweise nur einige Nanometer dick ist. Vorliegend ist es beispielweise vorteilhaft, wenn ein Kern aus einem weichen und/oder elastischen Material vorliegt, der mit einer Hülle, die die Dispersionsstabilität in der Harzmatrix unterstützt und/oder gewährleistet. Dazu ist die Hülle bevorzugt aus einem Material, das die gleichen oder ähnlichen funktionalen Gruppen oberflächlich zeigt wie die Harzmatrix selbst. Beispielsweise kann eine epoxyfunktionale, silanisierte und/oder glycidoxymodifizierte Hülle, z.B. eine (Meth)Acrylat-Styrol-Hülle, auf den Kern aufgepfropft vorliegen.

Beispielsweise werden Core/Shell Partikel eingesetzt, deren Kern zumindest eine der folgenden Verbindungen, als Einzelverbindung, als Blend und/oder als Copolymer umfasst: Polybutadien, Siloxankautschuk, Acrylat-Kautschuk, (Meth)Acrylat-Kautschuk, Dienkautschuk sowie beliebige Kombinationen und/oder Gemische davon.

Im Kern liegt dabei beispielsweise die Vorstufe eines voll durchgehärteten Polymers vor, ein Material, das immer noch statistisch auftretende gut chemisch angreifbare funktionale Gruppen an der Oberfläche aufweist, wie beispielsweise Kohlenstoff-Kohlenstoff-, Kohlenstoff-Silizium-, Kohlenstoff -Sauerstoff-, Kohlenstoff-Schwefel-, Kohlenstoff-Stickstoff- und/oder Kohlenstoff-Phosphor- Doppel- oder Dreifachbindungen. So kann die Shell, also die Hülle auf den Kern auch durch Aufpfropfen einer an die Harzmatrix angepassten, beispielsweise epoxidfunktionalen Verbindung auf den Kern durch beispielsweise radikalische Polymerisation und/oder thermisch und/oder durch Bestrahlung aufgebracht werden.

Die Hülle oder Shell der Core/Shell "CS"Nanopartikel ist beispielsweise epoxyfunktional und dadurch an die auf Epoxidharzbasierende Harzmatrix angepasst, so dass die CS-Nanopartikel kinetisch stabil in der Harzmatrix vorliegen.

Es hat sich gezeigt, dass beispielsweise Nanopartikel mit einer Korngröße im Bereich von 10nm bis 350nm, beispielsweise im Bereich von ca. 50-250 nm Abmessung, insbesondere im Bereich von 80-120nm des mittleren Partikeldurchmesser, dem sogenannten d50-Wert als Zugabe zur Formulierung des Underfill-Materials geeignet sind, insbesondere wenn die Nanopartikel deagglomeriert und/oder kinetisch stabil in einem Epoxidbasisharz vorliegen. So ist es möglich, eine stöchiometrisch eingestellte Mischung aus Epoxidharz, Core/Shell-Nanopartikeln und - je nach Variante 1K- oder 2K- optionalem Härter, z.B. Phthalsäureanhydrid-derivat, zu bereiten, die dem kommerziellen Underfill-Material beigemengt werden kann.

Alle als Underfill-Material bekanntermaßen einsetzbare Harze und Harzmischungen können als Harzmatrix im Sinne der Erfindung eingesetzt werden. Das Harz oder die Harzmischung umfasst beispielsweise ein Silikon, Epoxid, Epoxynovolak und/oder Bisphenoldiglycidylether. Das Harz kann ein Reinstoff oder ein Gemisch verschiedener Harze umfassen. Beispielsweise ist das Harz ein Gemisch verschiedener bei Raumtemperatur und Normaldruck flüssiger Epoxidharze, darunter auch Gemische mit Bisphenol-A-Diglycidylether, Bisphenol-F-Diglycidylether, Epoxynovolake und/oder cycloaliphatische Epoxidharz(e) beispielsweise ein Gemisch mit 3,4-Epoxycyclohexylmethyl-3',4'-epoxycyclohexancarboxylat.

Das Harz liegt entweder als 1K- oder als 2K-Formulierung vor, wobei im Fall der einkomponentigen 1K-Formulierung
- beispielsweise ein Polymerisationsbeschleuniger im Bereich von 0.01-5 Gew.-%, bevorzugt 0.5-4 Gew.-%, am bevorzugtesten 0.8-3 Gew.-%, bezogen auf die Gesamtmischung, beispielsweise zur Verwendung für die Epoxyhomopolymerisation ohne Anhydridhärter und/oder Polyester-Copolymerisation mit Anhydridhärter auf Basis von
- flüssigen und/oder bei Raumtemperatur festen tertiären Aminen, Dicyandiamiden, Uronderivaten und/oder Imidazolderivaten,
- thermisch-aktivierbaren, geblockten/latenten, kationischen Supersäurederivaten auf Basis organischer Kationen und SbF₆-, PF₆-, und/oder BF₄-Anionen, grundsätzlich alle latenten Supersäurederivate,
- kationische Supersäurederivate auf Basis organischer Kationen und SbF₆-, PF₆-, und/oder BF₄-Anionen und/oder grundsätzlich alle nicht-latenten Supersäurederivate, und/oder
- thermisch-aktivierbaren, geblockten, anionischen Superbasenderivaten (latente Superbasen)
- anionischen Superbasenderivaten (nicht-latente Superbasen)

Im Fall der 2K-Formulierung liegt andererseits immer ein Härter vor, der in ungefähr stöchiometrischem Anteil im flüssigen Harz-Gemisch, das die Basis des Underfillers darstellt, vorgesehen ist.

Optional kann als Härter ein Härter auf Basis von
- Aminen,
- Anhydriden wie Methylhexahydrophthalsäureanhydrid, bevorzugt Methyltetrahydrophthalsäureanhydrid und/oder Methyl-Norbornen-2,3-dicarbonsäureanhydrid und/oder
- Mischungen der vorgenannten Härter für die Polymerisierung, beispielsweise die Polyesterhärtung, im flüssigen Underfiller vorliegen.

In der Formulierung für das flüssige Harzgemisch, das als Underfiller aufgetragen wird, kann zudem optional eine oder mehrere Fraktionen an Mikrofüllstoffen, also Füllstoff dessen Partikel im Größenbereich "µm" sind, vorliegen:
Beispielsweise sind diese:
   - mineralischer und/oder anorganischer Mikrofüllstoff und/oder
   - mineralischer und/oder anorganischer Mikrofüllstoff, zumindest zum Teil mit oberflächenmodifizierten Mikrofüllstoff-Partikeln. Die Oberflächenmodifikation umfasst beispielsweise Epoxy- und/oder Aminosilane - im Englischen als "EST" und/oder "AST" bezeichnet,
Beispielsweise liegen diese Mikrofüllstoffe in Mengen
   - im Bereich von 50-90 Gew.-%, bevorzugt 55-80 Gew.-%, am bevorzugtesten im Bereich von 60-75 Gew.-% bezogen auf die Gesamtmischung des flüssigen Underfillers, vor.
   - Die hier beispielsweise eingesetzten Mikrofüllstoffe liegen mit mittleren Partikeldurchmessern d50 von 1-100µm, bevorzugt 2-50µm, am bevorzugtesten im Bereich von 3-15µm vor.

Vom Material her sind die Mikrofüllstoffe beispielsweise auf Basis von
- Siliziumdioxid, splittrig und/oder bevorzugt sphärisch (mit Sphärizität >90%) mit kristalliner (Quarzmehl, engl. crystalline silica flour) und/oder amorpher Kristallstruktur (Quarzgut, engl. fused silica)
- Aluminiumoxid, splittrig und/oder sphärisch (mit Sphärizität >90%),
- sphärisch-gestaltetes, hexagonales Bornitrid
- Aluminiumnitrid, insbesondere hydrolysestabiles Aluminiumnitrid.
- Alle genannten Materialien können einzeln oder in beliebigen Kombinationen, oberflächenmodifiziert oder nicht-obrflächenmodifiziert als Mikrofüllstoff im Underfiller-Material vorliegen.

In der Formulierung für das flüssige Harzgemisch, das als Underfiller aufgetragen wird kann zudem optional ein oder mehrere Additiv(e) im Bereich von 0.1-5 Gew.-%, bezogen auf die Gesamtmischung, auf Basis von
- organischen und/oder anorganischen Pigmenten
- Verlaufsadditiven zur Verbesserung der Spreitung und/oder Benetzung auf Substraten,
- Entschäumern/Defoamern (z.B. Byk Additives)
- Entlüftern/Air Release Agents (z.B. Byk Additives)
- oberflächenaktiven Haftvermittlern und/oder silizumorganischen Precursoren, wie z.B. Dynasylan GLYMO ((3-Glycidyloxypropyl)trimethoxysilan) und Dynasylan GLYEO ((3-Glycidyloxypropyl)triethoxysilan)
- oberflächenaktiven Rheologiemodifikatoren
vorgesehen sein.

Für den Fall, dass zusätzlich isolierende Eigenschaften des Underfiller-Materials in der Applikation gefordert sind, wie z. B. bei leistungselektronischen Anwendungen, bei denen auf kurzen Strecken hohe Potentialunterschiede elektrisch sicher zu trennen sind, ist eine Anhaftung an unterschiedlichen Oberflächen der Chip- und Substratmaterialien nicht nur vorteilhaft, sondern geradezu unerlässlich. Ebenso sind initiale und fortschreitende Rissbildungen unter thermomechanischer Wechselbeanspruchung so zu verringern, dass sie während der Lebensdauer des Produktes nicht zu Ausfällen führen. Dies ist auf Basis der bisherigen Untersuchungen mit derzeitig verfügbaren Underfiller-Materialien nicht oder nur unzureichend realisierbar.

Es ist eine allgemeine Erkenntnis der vorliegenden Erfindung, dass Underfill-Materialien und/oder Dam&Fill-Harze als herkömmliche Gießharze betrachtet werden können und die genannten chemischen Bestandteile wie bei Gießharzen nachweisbar sind, z.B. durch ATR-IR-Spektroskopie. Der Füllstoffanteil und die Füllstoffform können durch Veraschung, Korngrößenverteilungsmessung, Dichtebestimmung und/oder Rasterelektronenmikroskopie und/oder EDX-Analyse bildlich dargestellt werden. Die Nanopartikel liegen deagglomeriert in der organischen Polymermatrix vor und können durch hochauflösende Rasterelektronenmikroskopie in Bruchbildern verbildlicht werden (vgl. Dissertation M. Übler, Universität Erlangen, 2010).

Als "Dam&Fill"- Verfahren wird vorliegend bezeichnet, wenn auf dem Substrat, der Leiterplatte und/oder der Platine durch ein isolierendes Material ein Damm aufgebaut wird, der quasi ein Becken bildet, in das die flüssige Reaktionsharzmischung eingefüllt werden kann. Das Becken bleibt beispielsweise auch nach der Fertigstellung des Halbleiterbauelements erhalten.

### Detaillierte Beschreibung der Ausführungsbeispiele

### Beispielhafte Ausführungsformen der Erfindung:

### Beispiel 1 eines Underfill-Materials:

Es wurde ein kommerzieller 1K-Underfiller mit nativen 60 Gew.-% Füllstoff (Quarzmehl und Quarzgut) auf Epoxidharzbasis (hauptsächlich Bisphenol-A-Diglycidylether) und schon vorhandenem (unbekannten, nicht im MSDS angegebenem) Beschleuniger im Speedmixerbehälter bei Raumtemperatur vorgelegt und eine nanopartikelhaltige Epoxy-/Anhydridmischung mit 1:0.95-molarer Oxiran/Anhydrid-Stöchiometrie aus Bisphenol-A-Diglycidylether (Epon 828-äquivalente Type) sowie Methyltetrahydrophthalsäureanhydrid mit ca. 15%igem Anteil an deagglomerierten Core-Shell-Nanopartikeln unter 2-3minütigem Rühren bei 2000 U/min beigemengt.

Nach dem innigen, kurzen Mischen bei Raumtemperatur konnte so eine ca. 2%ige Nanopartikelmischung im sonst 60%ig mit Mineralfüllstoff gefüllten 1K-Underfiller realisiert werden. Dabei fungiert der vorhandene Beschleuniger im 1K-Underfiller auch als Beschleuniger für die nanopartikelhaltige Epoxy-/Anhydridmischung. Im vorliegenden Beispiel wurde eine nanopartikelhaltige Epoxy-/Anhydridmischung eingesetzt, die reaktionsstöchiometrisch korrekt voreingestellt ist. Daher führt die Zugabe dieser zusätzlichen Epoxy-/Anhydridmischung zu keinem signifikanten Glasübergangsabfall des ursprünglichen 1K-Underfiller-Materials.

Die hier eingesetzte nanopartikelhaltige, reine Epoxy-/Anhydridmischung ist per se beschleunigerfrei und damit praktisch unbegrenzt lagerbar. Im Vergleich dazu wird das 1k-Underfiller-Material bevorzugt eingefroren und bei Temperaturen von -40°C bis -25°C gelagert. Die nanopartikelhaltige Epoxy-/Anhydridmischung ist beispielsweise und bevorzugt sedimentationsstabil, so dass die Nanopartikel in der flüssigen Epoxy-/Anhydridmischung nicht agglomerieren und sich nicht am Boden absetzen.

Die erhaltene, nanomodifizierte 1K-Underfiller-Mischung wurde aus dem Speedmixerbehälter in eine standardisierte Dispenser-Kartusche bei Raumtemperatur überführt und mit offener Spitzenöffnung aufrechtstehend im Vakuumofen bei <1mbar bei 23°C bis zur Blasenfreiheit über ca. eine Stunde entgast, kappenverschlossen, im Anschluss bei -25°C eingefroren und zur weiteren Verwendung bereitgestellt. Damit wurden Chips bei 80°C Substrattemperatur und 23°C Harztemperatur vergossen, im Anschluss 1h/110°C sowie 1h/150°C ausgehärtet. Es zeigten sich im Schliffbild keine Risse an den Kanten des Chips und des keramischen Schaltungsträgers und keine Delaminationen an der unterfüllten Chip- und Keramikunterseite, was eine deutliche Verbesserung im Vergleich mit den Referenzproben mit einem kommerziell erhältlichen, nanopartikelfreien 1K-Underfiller-Materialien darstellt, die - siehe Figuren 1 und 2 - deutliche Rissbildungen und Delaminationen zeigen.

Es wurden dazu eine Reihe von Underfiller-Materialien des Marktes auf Ihre Tauglichkeit gescreent. Viele der handelsüblichen Underfiller-Materialien führten nach dem Verguss bei 60 bis 80°C Substrattemperatur sowie einer Aushärtung zwischen 30 und 60 Minuten bei 130 bis 150°C und anschließender Schliffpräparation zu den in den Figuren 1 und 2 abgebildeten Rissphänomenen an den Ecken und/oder Kanten der Chips und Substratmaterialien sowie zu flächigen Delaminationen mit Spalten von bis zu 30µm. Somit konnte eindrucksvoll im Vergleich dazu mit den Underfill-Materialien gemäß beispielhafter Ausführungsformen der Erfindung - siehe Figuren 3 und 4 - gezeigt werden, dass sich die Underfill-Materialien nach dem Stand der Technik, insbesondere für Leistungselektronikaufbauten, als Underfiller-Materialien und als Isolationswerkstoff nicht gut eigenen, da sie weder den Anforderungen an die mechanische Stabilität noch den benötigten Isoliereigenschaften, die eine Anhaftung an den Fügepartnern voraussetzen, genügen.

Die Underfiller-Materialien nach beispielhaften Ausführungsformen der Erfindung lösen demnach ein Problem des derzeitigen Standes der Technik. Erwähnte Phänomene bezüglich Rissbildung und Ablösung vom Halbleiterchip, einer Leitung, dem Substrat und den Kontakten werden durch die Zugabe der Nanofüllstoffe gelöst. Der Vergleich der Underfiller-Materialien von beispielhaften Ausführungsformen der Erfindung - Figuren 3 und 4 - mit dem handelsüblichen Stand der Technik, Figuren 1 und 2, sind in den nachfolgenden Figuren 1 bis 4 mittels Schliffbildern dargestellt.

Figur 1 - Stand der Technik - zeigt einen Ausschnitt aus einem herkömmlichen Halbleiterbauelement, eine Stelle im Schliffbild, die zeigt, wie Chip in den Underfiller eingebettet ist. Linksseitig wird die Ecke und Kante gezeigt, die hellere Fläche zeigt den Halbleiterchip 2 und die dunklere Fläche das Underfill-Material 1, jeweils nach Verguss und im ausgehärteten Zustand. Rechtsseitig in Figur 1 sieht man in einer geringeren Auflösung die Darstellung der Längskante mit der Grenzfläche Halbleiterchip 2 und Underfiller 1.

Es wurde dafür Underfill-Material 1 auf Basis von Araldite^{®} CY 179 mit anhydridischem Härter MTHPA eingesetzt. Dargestellt sind in Figur 1 zwei Schliffbilder von Grenzflächen des gehärteten Underfillers 1 und eines damit unterfüllten Halbleiterchips 2 nach dem Stand der Technik. Die gezeigten Aufnahmen geben eine Referenzprobe wieder, wobei beim Underfill die Substrattemperatur ca. 80°C betrug und die Aushärtetemperatur ca. 1 h bei 150°C. Zu erkennen ist eine deutliche Rissneigung - siehe Risse 3 im Underfiller 1- und fehlende Haftung 4 des Underfillers 1 an den Kanten des Halbleiterchips 2.

Die Schliffbilder der Figur 1 zeigen die Probleme der Rissbildung 3 im Underfiller 1 und mangelnde Haftung 4 des Underfillers 1 an den Kanten und Ecken des Halbleiterchips 2. In Figur 1 linke Seite erkennt man einen Riss 3 von 6µm im Underfiller, sowie einen nicht haftenden Bereich von 3µm links und sogar 5µm rechts. Wo der Underfiller 1 nicht stoffschlüssig, also haftend, mit dem Halbleiterchip 2 eine gemeinsame Grenzfläche bildend, am Halbleiterchip 2 anschließt, können, speziell in der Leistungselektronik, elektrische Durchschläge auftreten, die gegebenenfalls zur Zerstörung des gesamten Halbleiterbauelements führen können.

Figur 2 zeigt ein weiteres Schliffbild der gleichen Referenzprobe nach dem Stand der Technik wie Figur 1, wobei hier der Rissfortschritt 5 nach unten ins Substrat 6 vom Riss 3 im Underfiller 1 - siehe Figur 1 linke Seite - erkennbar ist. Das Schliffbild der Figur 2 entstand nach thermomechanischer Wechselbeanspruchung des hier in Ausschnitten gezeigten Halbleiterbauelements.

Figur 3 zeigt einen Ausschnitt aus einem Halbleiterbauelement vergleichbar zu den in Figuren 1 gezeigten Ausschnitten, allerdings hier mit einem Halbleiterbauelement nach einer beispielhaften Ausführungsform der Erfindung. Das hier gezeigte Underfill-Material liegt stoff- und formschlüssig in den Spalten und/oder um die Leitungen herum angrenzenden Underfill-Materials vor. Das Underfill-Material 7 baut auf dem in Figur 1 und 2 gezeigten herkömmlichen Underfill-Materialien auf, es umfasst, aber zusätzlich Nanopartikel in einer Menge von 2,01Gew %. Bei vergleichbarer Verarbeitung - Substrattemperatur beim Unterfüllen ca. 80°C und Aushärtetemperatur 1 h bei 110°C und eine weitere Stunde bei 150°C zeigen sich ganz deutlich die Unterschiede im Schliffbild zu den Darstellungen der Figuren 1 und 2, hier ist keine Rissbildung und keine Ablösungen bei gleicher Auflösung erkennbar. So kann der Vorteil der hier erstmals vorgeschlagenen technischen Lösung eines stoff- und formschlüssigen klar nachvollzogen werden.

Mit Figur 3 vergleichbare Schliffbilder konnten auch von weiteren beispielhaften Ausführungsformen der Erfindung aufgenommen werden - siehe Figur 4-. Auch beispielsweise bei Basisharz BADGE ebenfalls mit MTHPA-Anhydrid als Härter, mit 1,95Gew% Nanopartikel und gleichen Underfill-Verfahrenstemperaturen und -zeiten, konnten vergleichbare Schliffbilder ohne Rissbildung und ohne Ablösung erhalten werden.

Diese sind in Figur 4 gezeigt. Figur 4 zeigt, wie Figur 3 eine stoff- und formschlüssige Ummantelung und Verbindung zwischen dem Halbleiterchip 2 und dem Underfill 7. Dies ist nur mit Underfill-Material nach Ausführungsbeispielen der Erfindung, also mit Nanopartikulärer Füllung, möglich.

Zur Erhöhung der Teilentladungsresistenz können dem Underfill-Material beispielsweise Additive in Form von epoxidharzverträglichen Polysiloxanen beigemengt werden, z.B. 1,3-Bis-(3-Glycidyloxypropyl) tetramethyldisiloxan, Poly-[dimethylsiloxan-co-(2-(3,4-epoxycyclohexyl)-ethyl)methylsiloxan, glycidoxyfunktionale Silikon-polymere (z.B. Wacker Silres HP1250), aminofunktionelles Methylphenylsilikonharz (z.B. Wacker Silres HP2020) oder Silikon-Epoxid-Hybridharze (z.B: Evonik Silikopon ED, Evonik Silikopon EF).

### Beispiel 2 einer weiteren Ausführungsform der Erfindung:

### Beispielhaft wurden

- ein nanopartikelfreies, cycloaliphatisches Epoxidharz auf Basis 3,4-Epoxycyclohexylmethyl-3',4'-epoxycyclohexancarboxylat, z.B. Huntsman Araldite CY179; in einer Menge von 66 Masseteilen,
- ein nanopartikelhaltiges Epoxidharz auf Basis 3,4-Epoxycyclohexylmethyl-3',4'-epoxycyclohexancarboxylat mit 30 Gew.-% Core/Shell-Nanopartikeln auf Basis eines Polybutadienkerns mit glycidoxymodifizierter (Meth)acrylat/Polystyrol mit d50 ~ 100nm in einer Menge von 34 Masseteilen,
- Methyltetrahydrophthalsäureanhydrid (z.B. Huntsman Aradur HY917 und/oder Aradur HY918) in einer Menge von 103 Masseteilen und
- Imidazolbeschleuniger des Typs 1-Benzyl-2-Methylimidazol in einer Menge von 2 Masseteilen
   im Speedmixerbehälter vorgelegt und 5min bei 3000 U/min homogenisiert, anschließend im Vakuum bei ca. 1mbar bei Raumtemperatur entgast und in Kartuschen überführt.

Dieses sedimentationsstabile, dünnflüssige, mikrofüllstoffpartikelfreie, aber nanopartikelhaltige flüssige Underfill-Material mit 4.95 Gew.-% Nanopartikel zeigt eine Gelzeit nach einschlägig bekannter Gelnorm (12g, Alublock) von 116 Stunden bei 23°C sowie 1.25h bei 85°C.

Bei diesem Ausführungsbeispiel der Erfindung liegen 205 Masseteile insgesamt vor, davon sind 34 Masseteile das flüssige, vorgefertigte Epoxidharz mit den deagglomerierten C/S Nanopartikel.

Dieses Underfill-Material wurde zum Unterfüllen und/oder Spaltausguss von 85°C heißen Substraten nach dem Dam&Fill-Verfahren benutzt, wobei das zu isolierende Substrat vorher mittels eines aufstehenden, geschlossenen Dammes aus weichem Polymer umgeben und sodann mit der flüssigen Underfill-Material-Reaktionsharzmischung verfüllt wird. Das umschlossene Substrat wird wie in ein Becken zur Ausbildung der isolierenden Schicht aufgefüllt. Es zeigte sich für das vorliegend beschriebene Beispiel eine hervorragende Füllwirkung mit freiwilliger Spreitung des Underfill-Materials mit beträchtlicher Kapillarwirkung, bei der auch kleinste Spalte und Hinterschneidungen vergossen werden konnten. Die Aushärtung bei 1h/150°C erfolgte nach der Gelierung bei 1h/85°C zur Ausbildung des elektrisch isolierenden Hochpolymeren.

Durch DSC-Analyse mit dem handelsüblichen Gerät Netzsch DSC 204 F1 Phoenix in einer Heizrate von 10 K/min ergab sich eine sehr hohe Glasübergangstemperatur von ca. 205°C - Auswertung der halben Höhe bzw. des Wendepunktes- und eine lineare thermische Ausdehnung unterhalb der Glasübergangstemperatur von ca. 70 µm/(m*K). Diese Mischung kann entsprechend mit einem höheren Anteil an CoreShell-Nanopartikeln von bis zu 16 Gew.-% in einer mikrofüllstofffreien Gesamtmischung weiter hinsichtlich der Bruchzähigkeit modifiziert werden, sodass sukzessive ein immer besser gut fließfähiges Underfill-Material (Dynamische Viskosität <20 Pa*s bei Raumtemperatur 25°C und Normaldruck) mit hoher, nach Aushärtung, resultierender Werkstoffbruchzähigkeit und sehr hoher Glasübergangstemperatur erhalten wird.

Eine entsprechende Mischung als weitere beispielhafte Ausführungsform der vorliegenden Erfindung mit 16.4 Gew.-% Nanopartikeln ist erhältlich durch Vermengung von
- nanopartikelhaltigem Epoxidharz auf Basis 3,4-Epoxycyclohexylmethyl-3',4'-epoxycyclohexancarboxylat mit 30 Gew.-% Core/Shell-Nanopartikeln auf Basis eines Polybutadienkerns mit glycidoxymodifizierter (Meth)acrylat/Polystyrol mit d50 ~ 100nm in einer Menge von 100 Masseteilen mit
- Methyltetrahydrophthalsäureanhydrid (z.B. Huntsman Aradur HY917 und/oder Aradur HY918) in einer Menge von 80,50 Masseteilen sowie
- Imidazolbeschleuniger des Typs 1-Benzyl-2-Methylimidazol in einer Menge von 2 Masseteilen.

Es gibt bezüglich der in einem flüssigen Harz deagglomeriert vorliegenden Core/Shell-Nanopartikel keine Beschränkung auf Epoxidharze allgemein und schon gar nicht auf Epoxidharze des Typs 3,4-Epoxycyclohexylmethyl-3',4'-epoxycyclohexancarboxylat. Es ist ebenso denkbar, nanopartikelhaltige und/oder flüssige Silikon- und/oder Epoxidharzformulierungen mit gleichen und/oder anderen Core/Shell-Nanopartikeln, beispielsweise solche auf Basis eines Polybutadienkerns, besonders bevorzugt mit Oberflächenmodifikation in Form von glycidoxymodifiziertem (Meth)acrylat/Polystyrol, beispielsweise einer mittlere Korngröße mit d50 ~ 100-200nm zu verwenden, die als Harzmatrix Silikone, Bisphenol-A-Diglycidylether, Epoxynovolake und/oder Bisphenol-F-Diglycidylether aufweisen. Beispielsweise werden die Nanopartikel als Füllstofffraktion in einer flüssigen Harzmatrix deagglomeriert vorliegend zu einer ansonsten handelsüblichen Underfill-Material-Formulierung zugegeben.

Die Zumischung von Mikrofüllstoffpartikeln erfolgt bevorzugt über sphärische Mikrofüllstoffe, diese können amorph vorliegen oder teilweise oder ganz kristallin sein. Beispielsweise eigenen sich Quarzmehle und/oder Quarzgute.

Beispielsweise haben die Mikrofüllstoffe d50-Werte von ~5-20µm, wobei wegen des Underfill Vorgangs in dünne Spalten die d₁₀₀ Werte beispielsweise unter 200µm, bevorzugt bei unter 150µm, insbesondere bei unter 120µm und ganz besonders bevorzugt unter 100 µm liegen.

Die Mikrofüllstoffe haben einen Füllgrad von bis zu 90 Gew.% im Underfill-Material. Beispielsweise liegt Mikrofüllstoff im Underfill-Material im Bereich von 60Gew% bis 80Gew% Füllgrad bezogen auf die Gesamtmischung des Underfill-Materials vor.

So kann der resultierende lineare, thermische Ausdehnungskoeffizient des ausgehärteten Werkstoffes von ca. 70 µm/(m*K) der Referenz einer mikrofüllstoff-freien Probe auf deutlich geringere Werte von weniger als 30 µm/(m*K) der Mikrofüllstoff-gefüllten ansonsten unveränderten Probe reduziert werden.

Auf diese, nämlich mikrofüllstoff-gefüllte Weise wird das Underfill-Material und/oder das Dam&Fill-Reaktionsgut zusätzlich deutlich bruchzäher und im thermischen Ausdehnungsverhalten an das zu umhüllende Substrat, den Chip und/oder die Leiterplatte angeglichen, was die Delaminations-Neigung des Underfill-Materials vom Substrat, Chip und/oder von der Platine bei thermischer und/oder mechanischer Belastung wirkungsvoll vermindert oder gar unterdrückt.

Durch die Erfindung wird erstmals die Einführung von deagglomeriert vorliegenden Nanopartikeln in die Reaktionsharzmischung, die als flüssiges Underfill-Material vorliegt, vorgeschlagen, die, ohne thermomechanische Beeinträchtigungen des Underfill-Materials zu verursachen, dessen Rissbeständigkeit und /oder Haftungseigenschaften gegenüber dem bekannten Stand der Technik deutlich verbessern.

## Patentansprüche

1. Halbleiterbauelement, einen Halbleiterchip auf einem Substrat mit einer Vielzahl von Leitungen und Kontakten umfassend, so dass die Vielzahl der Leitungen und Kontakte die Schaltungen auf der Oberfläche des Halbleiterchips mit den Kontakten auf dem Substrat verbinden, wobei zwischen dem Halbleiterchip und dem Substrat sowie um die Vielzahl von Leitungen und Kontakten herum ein elektrisch isolierendes Underfill-Material jeweils form- und stoffschlüssig vorgesehen ist, das in einer Harzmatrix de-agglomerierte Nanopartikel und Mikrofüllstoffe umfasst.

2. Halbleiterbauelement nach Anspruch 1, wobei die Harzmatrix des Underfill-Materials ein bei Raumtemperatur und Normaldruck flüssiges Epoxidharz oder ein Gemisch flüssiger Epoxidharze umfasst.

3. Halbleiterbauelement nach einem der Ansprüche 1 oder 2, wobei die Mikrofüllstoffe im Underfill-Material in einer Menge von bis zu 90Gew% vorgesehen sind.

4. Halbleiterbauelement nach einem der vorhergehenden Ansprüche, wobei das Material der Mikrofüllstoffe im Underfill-Material ausgewählt ist aus der Gruppe von Siliziumdioxid, Aluminiumoxid, Bornitrid und/oder Aluminiumnitrid in beliebigen Mischungen und/oder Kombinationen.

5. Halbleiterbauelement nach einem der vorhergehenden Ansprüche, wobei die Nanopartikel im Underfill-Material in einer Menge von 0,3 Gew% bis 25 Gew% Underfill-Materials enthalten sind.

6. Halbleiterbauelement nach einem der vorhergehenden Ansprüche, wobei die Nanopartikel im Underfill-Material zumindest zum Teil Core/Shell Nanopartikel sind.

7. Halbleiterbauelement nach einem der vorhergehenden Ansprüche, wobei die Nanopartikel im Underfill-Material in einer Korngröße, handelsüblich angegeben im d50-Wert, im Bereich von 10 bis 350nm vorliegen.

8. Halbleiterbauelement nach einem der vorhergehenden Ansprüche, wobei die Kerne der Core/Shell Nanopartikel polymerhaltig, weich und/oder elastisch sind.

9. Halbleiterbauelement nach einem der vorhergehenden Ansprüche, wobei die Kerne der Core/Shell-Nanopartikel im Underfill-Material Polybutadien, Siloxankautschuk, Acrylat-Kautschuk, (Meth)acrylat-Kautschuk, Dienkautschuk sowie beliebige Kombinationen und/oder Gemische davon umfassen.

10. Halbleiterbauelement nach einem der vorhergehenden Ansprüche, wobei die Oberfläche der Kerne der Nanopartikel im Underfill-Material zumindest zum Teil statistisch verteilte reaktive funktionale Gruppen aufweisen, auf die eine Hülle aufgepfropft ist.

11. Halbleiterbauelement nach einem der vorhergehenden Ansprüche, wobei die Core/Shell-Nanopartikel im Underfill-Material zumindest zum Teil eine epoxyfunktionale, silanisierte und/oder glycidoxymodifizierte Hülle aufweisen.

12. Halbleiterbauelement nach einem der vorhergehenden Ansprüche, wobei die Nanopartikel im Underfill-Material zumindest zum Teil eine Hülle aus Styrol, insbesondere eine Hülle aus (Meth)Acrylat-Styrol aufweisen.

13. Halbleiterbauelement nach einem der vorhergehenden Ansprüche, wobei die Nanopartikel in das Underfill-Material zumindest zum Teil als deagglomeriert und in einem flüssigen Harz dispersionsstabil vorliegend eingebracht werden.

14. Halbleiterbauelement nach einem der vorhergehenden Ansprüche, das im Underfill-Verfahren herstellbar ist.

15. Halbleiterbauelement nach einem der vorhergehenden Ansprüche, das im Dam & Fill - Verfahren herstellbar ist.
